Europäisches Patentamt

European Patent Office

Office européen des brevets

(11) Publication number: **0 194 061**
**A2**

(12) **EUROPEAN PATENT APPLICATION**

(21) Application number: **86301022.9**

(22) Date of filing: **14.02.86**

(51) Int. Cl.⁴: **H 01 L 45/00**

(30) Priority: **28.02.85 JP 37579/85**

(43) Date of publication of application: **10.09.86**
**Bulletin 86/37**

(84) Designated Contracting States: **DE GB NL**

(71) Applicant: **TOKYO INSTITUTE OF TECHNOLOGY,**
**12-1 Ohokayama 2-chome Meguro-ku, Tokyo (JP)**

(72) Inventor: **Suematsu, Yasuharu, 450-48, Ohzenji Aso-ku,**
**Kawasaki City Kanagawa Pref. (JP)**

(74) Representative: **Barnard, Eric Edward et al, BROOKES &**
**MARTIN High Holborn House 52/54 High Holborn,**
**London WC1V 6SE (GB)**

(54) **Improvements in semiconductor structures and devices.**

(57) An artifical semiconductor (1) is composed a of multilayer structure with thin films of metal (1a) or insulator (1b) or semiconductor in alternation. The semiconductor (1) is combined with one or more other bodies (2, 3, 5) which may be of similar multi-layered construction but with a different period or film thickness to provide a diode, a transistor or an amplifying device with a high speed response to millimeter waves.

EP 0 194 061 A2

## IMPROVEMENTS IN SEMICONDUCTOR STRUCTURES AND DEVICES

### Field of the Invention

The present invention relates in general to semiconductor structures and devices such as diodes and transistors, and high-speed amplifying devices employing such structures.

### Background to the Invention

Conventional semiconductor structures and devices utilise semiconductor elements or compounds essentially of unitary nature with particular characteristics such as being electron donors and acceptors. In known semiconductor transistors, for example, amplifying characteristics are largely determined by the inherent nature of the materials and it is difficult to change such materials to realise the desired characteristics. Known devices also do not provide a very high response speed higher than the order of millimeter wavelengths.

### Summary of the Invention

A general object of the present invention is to provide improved semiconductor structures and devices with a wide range of characteristics changed more easily during manufacture and capable of being designed for a high speed response.

The present invention provides, in one aspect, an artificial semiconductor composed of alternate layers of thin metal films and thin insulator films or thin semiconductor films and thin metal or thin insulator films. The thickness of the films of each type are uniform but by changing the thickness of the films in unison to provide a different periodic relationship different characteristics can be achieved. The nature of the film materials themselves can be maintained however in contrast to conventional semiconductors.

A device such as a diode or transistor can be constructed from several such artificial semiconductors with different periods. Preferably to provide an amplifying device an artificial semiconductor constructed in accordance with the invention is sandwiched between two other bodies which may also be artificial semiconductors with a different period and the central multi-layered semiconductor has dimensions in the order of the mean free path of electrons. To achieve a high response speed waveguides serve to transfer signals into and out of the device.

The invention may be understood more readily, and various other aspects and features of the invention may become apparent, from consideration of the following description.

BRIEF DESCRIPTION OF DRAWINGS

In the accompanying drawings,

Figure 1 is a perspective view of an artificial semiconductor in the form of a thin film multi-layer structure constructed in accordance with the present invention;

Figure 2a is a diagram showing the relationshop between the amount of movement and the energy of electrons in the thin film multi-layer structure;

Figure 2b is a diagram depicting the bands of the thin film multi-layer structure;

Figure 3 is a diagram showing the variation of the energy according to the variation of the film period in the thin film multi-layer structure.

Figure 4 is a simplified cross-sectional view of a diode formed by two kinds of artificial semiconductors;

Figure 5 is a diagram depicting the V-I characteristics of the diode;

Figure 6(a) to 6(d) are diagrams showing the variation of electron conduction for voltages applied to two kinds of artificial semiconductors;

Figure 7 is a simplified cross-sectional view of a transistor device formed from three kinds of artificial semiconductors;

electron amplifying device constructed in accordance with the invention;

Figure 9 is a perspective view of a practical embodiment of the device shown in Figure 8; and

Figure 10 is a side view of a modified embodiment of an artificial semiconductor.

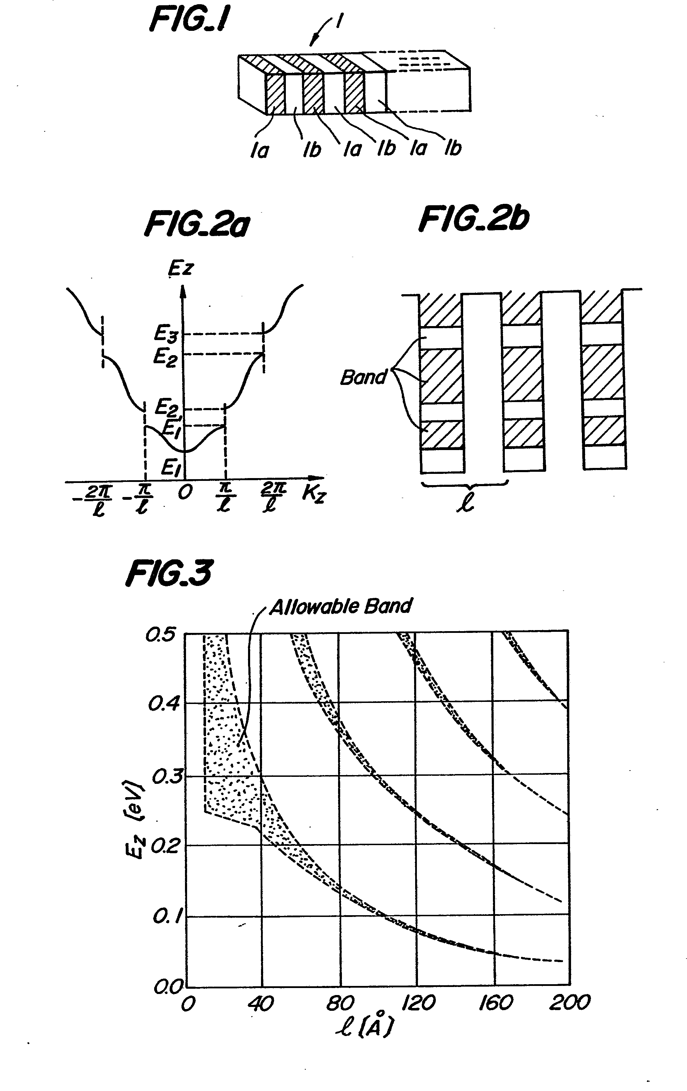

As shown in Figure 1, an artificial semiconductor 1 is manufactured in the form of a thin film multi-layer construction composed of thin metal films 1a interposed with thin insulator films 1b. Instead of adopting a multi-layer structure composed of thin metal films 1a and thin insulator films 1b, a structure composed of thin metal films interposed with thin semiconductor films or thin insulator films interposed with thin semiconductor films can be adopted and the multi-layered structure forming the artificial semiconductor can be combined with other bodies typically thick metal or insulator films. The principle of construction and operation of the artificial semiconductor 1 can be understood from Figures 2a, 2b and 3. Figure 2a shows the relationship between the amount of movement of electrons $K_Z$ and the energy $E_Z$, and Figure 2b shows the energy bands for an artificial semiconductor with films of equal thickness. In Figures 2a and 3, the unit $\ell$ designates the period of the combination of thin metal films 1a and thin insulator films 1b, for example, which is twice the film thickness in the case where both the types of films 1a, 1b have equal thickness. The electrons have energy levels determined by the periodic potential of the multi-layer structure and the allowable energy bands so the characteristics of the artificial semiconductor are similar to a conventional semiconductor. In general, each thin metal film has the same thickness as the other metal films 1a and each thin insulator film 1b has the same thickness as the other insulator films 1b. However, the thickness of the thin metal films 1a need not be the same with that of the thin insulator films 1b. In

a typical construction an artificial semiconductor is fabricated from alternate films of metal, such as Ag, Al, Au, Bi, Cr, Cu, Pb, Sn, Ti, W, $CoSi_2$, $NiSi_2$ interposed with films of insulating material such as C(diamond), $Al_2O_3$, $CaF_2$, $SiO_2$. The thickness of each metal film is 5-50Å and the thickness of each insulator film is 5-50Å with the period $\ell$ =10-100Å.

Although the same basic materials can be used in the thin film multi-layer structure, the energy bands can be varied by changing only the periodic form as can be seen from Figure 3, which shows the variation of energy bands caused by a variation of the film thickness. Therefore, artificial semiconductors having different characteristics may be obtained by varying the period of the structure i.e. by varying the thickness of the same types of film in unison.

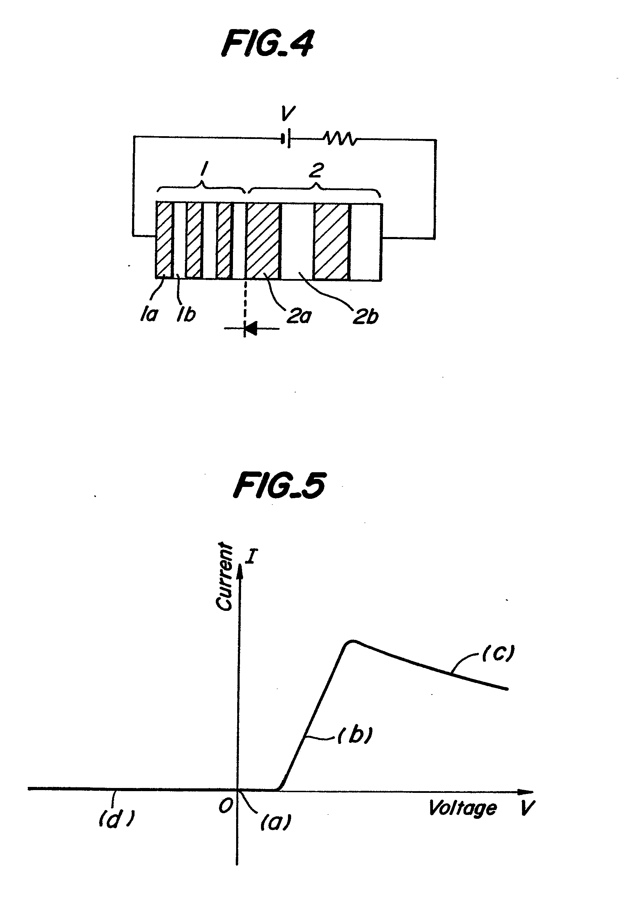

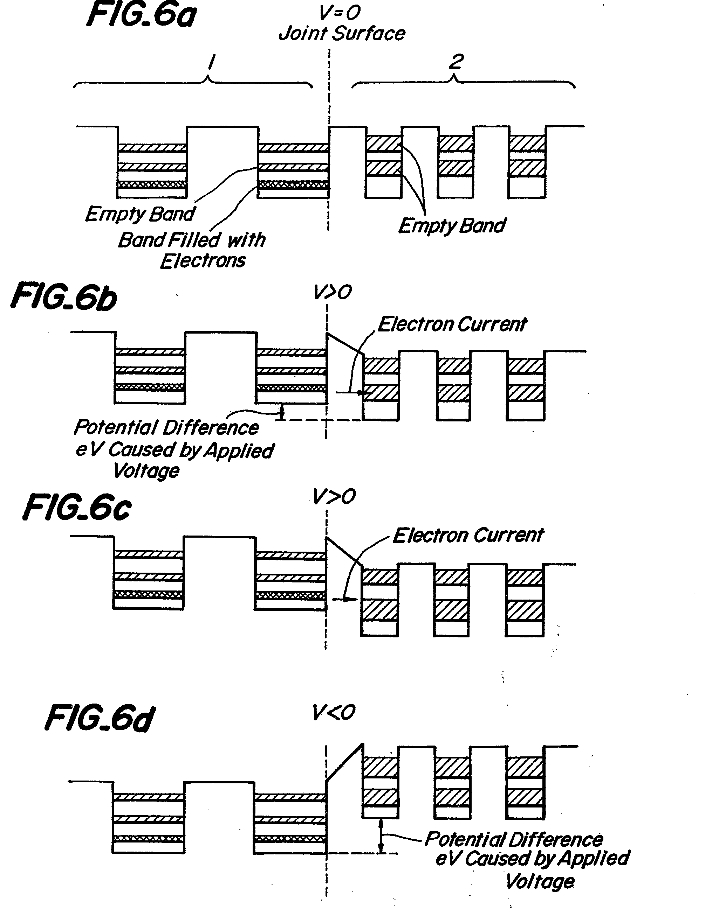

As can be seen from the simplified drawing shown in Figure 4, the aforementioned artificial semiconductor 1 with the characteristic thin film multi-layer structure and manufactured in the manner explained above is joined with a second artificial semiconductor 2 having a similar thin film multi-layered construction employing thin metal film 2a and thin insulator film 2b, for example, but with different period or different film thickness, at a junction to provide a diode. If the composite device is subjected to a dc voltage V as shown in the drawing and the voltage is varied as shown in Figure 5, the resultant conductivity characteristics are as shown. Referring to Figures 5 and 6, when the applied voltage V is equal to zero, i.e., V=0, as shown in Figure 5(a) and 6(a), the energy level of the band of the artificial semiconductor 1 filled with electrons is not coincident with the energy level of the band of the artificial semiconductor 2 which is deficient in electrons so that no current will flow through the device. As the applied voltage V is increased in the forward direction (V>0), Figure 5(b) and 6b, the level of the band of the artificial semiconductor 1 filled with electrons will become coincident with the level of the empty band of the artificial semiconductor 2 and electrons will begin to flow as shown by the arrow in Figure 6(b). When the voltage V is increased further, Figure 5(c), the energy level of the band of the artificial semiconductor 1 filled with electrons starts to shift from the level of the empty band of the artificial semiconductor 2 as shown in Figure 6(c) so that the current tends to decrease. If the applied voltage V is reversed (V<0), as shown in Figure 5(d) and 6(d) there is no coincidence between the energy band of the artificial semiconductor 1 filled with electrons and the empty band of the artificial semiconductor 2 and as shown in Figure 6(d) no current wil flow through the device.

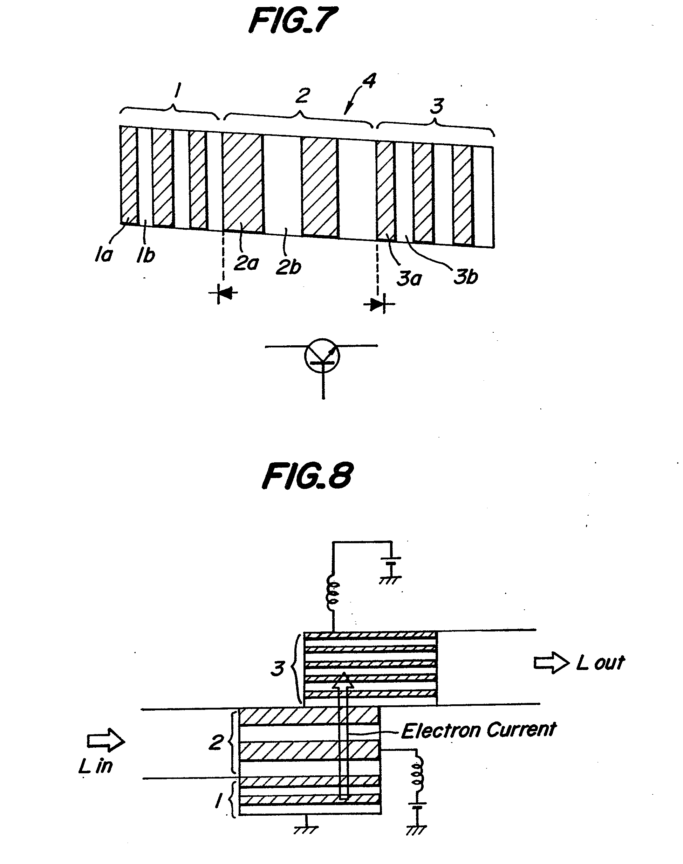

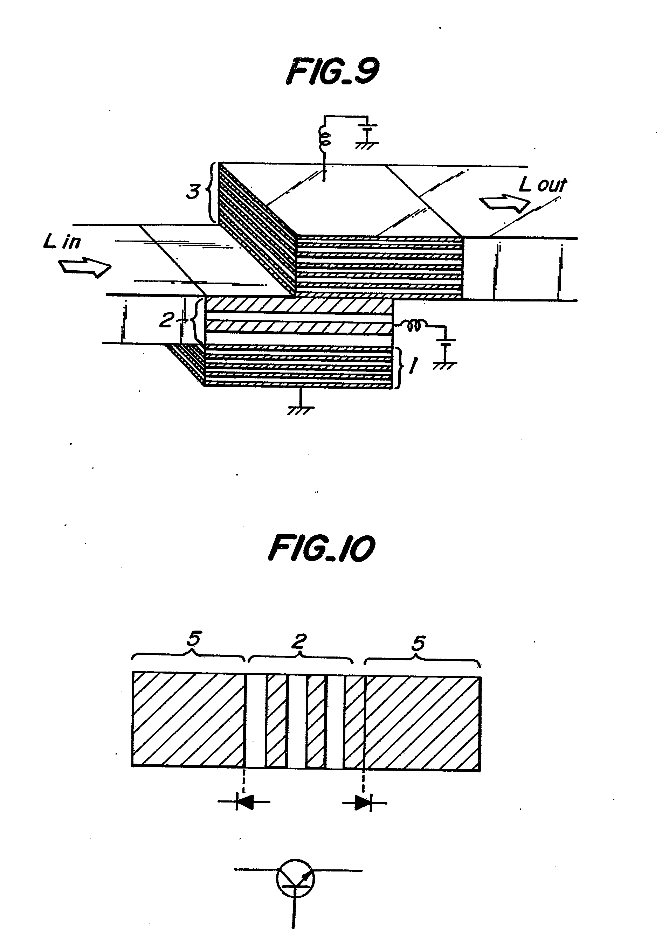

By the same principle, a transistor function can be obtained by making a transistor from artificial multi-layered semi-conductor structures as described. Thus, as shown in Figure 7, a transistor is composed of the series combination of the aforementioned two thin film multi-layer artificial semiconductors 1 and 2 and an artificial semiconductor 3 again of a thin film multi-layered construction formed of thin metal films 3a and thin insulator films 3b with a different period to that of at least the other element 2. By controlling the relative position and dimensions of the central semiconductor 2 which corresponds to the base of the transistor within the order of the mean free path of the electrons, electrons can be transferred from the artificial semiconductor 1 into the artificial semiconductor 2 and thence from the semiconductor 2 into the artificial semiconductor 3 with current gain or amplification for utilisation. Furthermore, by making the dimensions of the semiconductor 2 in the order of the mean free path of electrons, a high speed response, which can be used in applications with millimeter wavelengths may be realised. An ultra high speed electron ampliying device can be produced by applying this principle. As can be seen from Figures 8 and 9, a waveguide for the signal input "Lin" is coupled to either of the artificial semiconductors 1 or 2 and a waveguide for the signal output "Lout" is coupled to the artificial semiconductor 3.

Figure 10 depicts an alternative embodiment wherein the artificial semiconductors 1 and 3 are replaced by by thick metal films 5, respectively, to obtain a sandwich structure with the artificial multi-layered semiconductor 2 therebetween. By controlling the relative position and dimensions of the artificial semiconductor 2 in the order of the mean free path of electrons, an amplifying function can be obtained as before.

As has been explained previously, in the electron amplifying device or transistor according to the present invention, one kind of thin metal film and one kind of this insulator film (or thin metal film and thin semiconductor film, or thin semiconductor film and thin insulator film) are used and by merely changing the thin film structure, the semiconductor characteristics can be altered and accordingly, the transistor characteristics, such as its current amplification factor, can be designed over a wide range in a comparatively easy manner.

The structural elements and devices according to the present invention exhibit significant advantages compared with semiconductors formed from a single material.

CLAIMS

1. An artificial semiconductor composed of alternate layers of thin metal films (1a) and thin insulator films (1b) or thin semiconductor films and thin metal films (1a) or thin insulator films (1b).

2. A semiconductor according to claim 1, wherein the thickness of each type of film (1a, 1b) is the same as all the other films of that type.

3. A diode composed of a first artificial semiconductor body (1) and a second artificial semiconductor body (2) each semiconductor body (1, 2) being composed of alternate layers of thin metal films (1a) and thin insulator films (1b) or thin semiconductor films and thin films metal (1a) or thin insulator films (1b); wherein the thickness of the films (1a, 1b) of the first body (1) is different to the thickness of the films (2a, 2b) of the second body (2).

4. A transistor composed of three semiconductor bodies (1, 2, 3) at least one of the bodies (2) being sandwiched between the other two bodies (1, 3) and being composed of alternate layers of thin metal films (1a) and thin insulator films (1b) or thin semiconductor films and thin metal films (1a) or thin insulator films (1b).

5. A transistor composed of three bodies (2, 5, 5) one of the bodies (2) being sandwiched between the other two bodies (5, 5) and being in the form of an artificial semiconductor composed of alternate layers of thin metal films (1a) and thin insulator films (1b) or thin semiconductor films and thin metal films (1a) or thin insulator films (1b).

6. A transistor according to claim 5, wherein the other two bodies are thick metal films (5, 5).

7. A transistor according to claim 4, 5 or 6, wherein the central artificial semiconductor body (2) has its dimensions and relative disposition in the order of the mean free path of electrons.

8    0194061

8. An electron amplifing device comprising three semiconductor bodies (1, 2, 3) each body being a thin film multi-layer structure, formed from a plurality of layers (1a, 1b, 2a, 2b, 3a, 3b) of two kinds of thin film materials selected from metals, insulators or semiconductors, each body (1, 2, 3) having a different period ($\ell$); wherein one of the bodies (2) is interposed between the other two bodies (1, 3) and has its dimensions in the order of the mean free path of electrons.

9. An electron amplifying device comprising an artificial semiconductor body of thin film multi-layered structure composed of alternate layers of thin metal films (1a) and thin insulator films (1b) or thin semiconductor films and thin metal films (1a) or thin insulator films (1b) and two thick metal films (5) provided on opposite sides of the semiconductor body (2) to sandwich the latter therebetween, wherein the artificial semiconductor body (2) has its dimensions in the order of the mean free path of electrons.

10. A device according to claim 8 or 9 and further comprising a waveguide for coupling an input signal to one of the bodies (2) or thick films (5) and a waveguide coupled to another of the bodies (3) or thick films (5) for providing an amplified output signal with a high speed response.

FIG.1

Ia  Ib  Ia  Ib  Ia  Ib

FIG.2a

FIG.2b

FIG.3

# FIG.4

V

1    2

Ia  Ib        2a   2b

# FIG.5

Current  I

(c)

(b)

O    (a)    Voltage  V

(d)

**FIG.6a**

V=0
Joint Surface

1    2

Empty Band
Band Filled with
Electrons

Empty Band

**FIG.6b**

V>0

Electron Current

Potential Difference
eV Caused by Applied
Voltage

**FIG.6c**

V>0

Electron Current

**FIG.6d**

V<0

Potential Difference
eV Caused by Applied
Voltage

## FIG.7

## FIG.8

L in

3

2

1

L out

Electron Current

FIG.9

L in

L out

3

2

1

FIG.10

5

2

5